(19)

Europäisches Patentamt
European Patent Office
Office européen des brevets

(11) **EP 2 099 080 A1**

(12) **EUROPEAN PATENT APPLICATION**

(43) Date of publication:
**09.09.2009 Bulletin 2009/37**

(51) Int Cl.:
***H01L 39/24*** *(2006.01)*

(21) Application number: **09002671.7**

(22) Date of filing: **25.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **03.03.2008 JP 2008052183**

(71) Applicant: **Kabushiki Kaisha Kobe Seiko Sho (Kobe Steel, Ltd.)**
**Kobe-shi,**
**Hyogo 651-8585 (JP)**

(72) Inventors:
• **Kato, Hiroyuki**
  **Hyogo 651-2271 (JP)**
• **Hase, Takashi**
  **Hyogo 651-2271 (JP)**
• **Zaitsu, Kyoji**
  **Hyogo 651-2271 (JP)**

(74) Representative: **Müller-Boré & Partner**
**Patentanwälte**
**Grafinger Strasse 2**
**81671 München (DE)**

(54) **Nb3Sn superconducting wire manufactured by internal Sn process and precursor for manufacturing the same**

(57)     A precursor for manufacturing a Nb$_3$Sn superconducting wire by an internal diffusion process, includes: a multielement wire (12) including a bundle of a plurality of single-element wires (1) each including a Sn or Sn-based alloy core centrally disposed, and a Cu or Cu-based alloy matrix and a plurality of Nb or Nb-based alloy filaments surrounding the Sn or Sn-based alloy core; and a rod-like reinforcing member (9a,9b) disposed in and/or around the bundle of the single-element wires.

FIG. 9

EP 2 099 080 A1

**Description**

The present invention relates to a precursor (hereinafter, sometimes referred to as "superconducting wire precursor") for manufacturing a $Nb_3Sn$ superconducting wire by an internal Sn process and a $Nb_3Sn$ superconducting wire manufactured with such a precursor. In particular, the present invention relates to a $Nb_3Sn$ superconducting wire useful as a material for superconducting magnets and a precursor for such a $Nb_3Sn$ superconducting wire.

Superconducting wires are practically used in several fields. One example is in the manufacture of superconducting magnets used for high-resolution nuclear magnetic resonance (NMR) spectrometers, nuclear fusion devices, accelerators, and the like. In this field, to enhance resolution of NMR signals and to reduce time required for obtaining data, there is a demand for high magnetic field superconducting magnets. To make the higher magnetic field superconducting magnets and to reduce the size of superconducting magnets, improvements in superconducting wires for manufacturing superconducting magnets are required. In particular, there is a demand for improving superconducting coils used in the innermost portion of superconducting magnets.

$Nb_3Sn$ superconducting wires have been practically used for manufacturing superconducting magnets. $Nb_3Sn$ superconducting wires are mainly produced by a bronze process. In the bronze process, a plurality of cores composed of Nb or a Nb-based alloy are embedded in a Cu-Sn-based alloy (bronze) matrix to form a composite wire. The composite wire is subjected to a diameter reduction process such as extrusion or wire drawing, so that the cores are thinned down to form filaments (hereinafter, referred to as "Nb filaments"). A plurality of the composite wires each including the Nb filaments and the bronze matrix are bundled to form a wire group. The wire group is surrounded with a copper layer for stabilization (Cu stabilizer) and subjected to a diameter reduction process. The resulting wire group is subjected to a heat treatment (diffusion heat-treatment) at about 600°C to about 800°C, so that $Nb_3Sn$ compound layers are produced at the boundaries between the Nb filaments and the bronze matrix.

Unfortunately, in the bronze process, the solid solubility of Sn in bronze has a limit (15.8% by mass or less), and hence, the resulting $Nb_3Sn$ compound layers have a small thickness and degraded crystallinity. As a result, a high critical current density Jc cannot be achieved, which is a drawback of the bronze process. The size and production cost of superconducting magnets (hereinafter, the term "NMR magnets" is sometimes used to also refer to superconducting magnets) can be further reduced as wires for manufacturing NMR magnets have higher critical current density Jc. As wires for manufacturing NMR magnets have higher critical current density Jc, the areas of superconducting portions in the conductors can also be reduced, thereby reducing the production cost of the wires.

Other than the bronze process, $Nb_3Sn$ superconducting wires can be also manufactured by an internal Sn process. Unlike the bronze process, the internal Sn process (also referred to as an "internal diffusion process") has no solid solubility limit in terms of the Sn concentration. For this reason, the Sn concentration can be set as high as possible, and hence, a $Nb_3Sn$ phase of high quality can be produced, thereby achieving a high critical current density Jc. Thus, there has been a demand for the application of superconducting wires manufactured by an internal Sn process (hereinafter, sometimes referred to as "$Nb_3Sn$ superconducting wires manufactured by an internal Sn process") to NMR magnets.

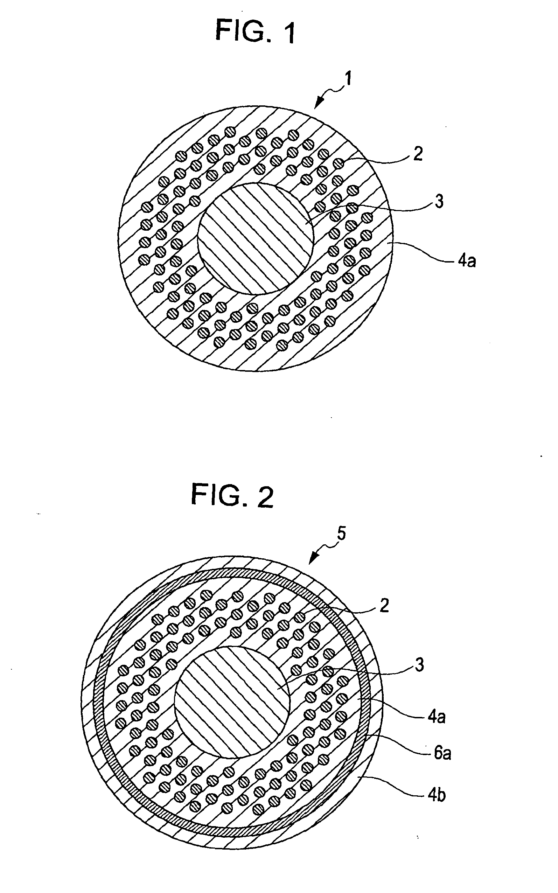

In an internal Sn process, as shown in Fig. 1 (a schematic view of a $Nb_3Sn$ superconducting wire precursor), a core composed of Sn or a Sn-based alloy (hereinafter, sometimes referred to as a "Sn-based metal core") 3 is embedded in the center of a Cu or Cu-based alloy matrix (hereinafter, sometimes referred to as a "Cu matrix") 4a. In the Cu matrix 4a surrounding the Sn-based metal core 3, a plurality of cores composed of Nb or a Nb-based alloy (hereinafter, sometimes referred to as "Nb filaments") 2 are disposed so as to be spaced from each other, thereby preparing a precursor (superconducting wire precursor) 1. The precursor 1 is subjected to wire drawing and then to a heat treatment (diffusion heat-treatment), so that Sn in the Sn-based metal core 3 is diffused to effect reaction between Sn and the Nb filaments 2, thereby producing a $Nb_3Sn$ phase in the wire (for example, see Japanese Unexamined Patent Application Publication No. 49-114389).

As shown in Fig. 2, a superconducting wire precursor may alternatively have a configuration (a superconducting wire precursor 5) that includes a Cu matrix 4a including the Nb filaments 2 and the Sn-based metal core 3, a Cu stabilizer layer 4b surrounding the Cu matrix 4a, and a diffusion barrier layer 6a disposed between the Cu matrix 4a and the Cu stabilizer layer 4b. The diffusion barrier layer 6a is constituted by, for example, a Nb layer, a Ta layer, or a bilayer including a Nb layer and a Ta layer. The diffusion barrier layer 6a prevents Sn in the Sn-based metal core 3 from diffusing to outside the Cu matrix 4a during a diffusion heat-treatment, thereby keeping the purity of Sn in the superconducting wire high.

The above-described superconducting wire precursor is manufactured by the following steps. Nb filaments are inserted into a Cu matrix tube, and subjected to a diameter reduction process such as extrusion or wire drawing to form a complex (generally having a hexagonal section). The complex is then cut into complexes with a proper length. These complexes are inserted into a billet that includes a Cu outer cylinder and is provided with or not provided with the diffusion barrier layer 6a. A Cu matrix (Cu solid billet) is disposed in the center of the billet and the resultant billet is subjected to extrusion. The Cu matrix in the center is mechanically perforated to prepare a pipe-like complex. Alternatively, a pipe-like complex may be prepared by the following steps. A hollow billet that includes a Cu outer cylinder and a Cu inner cylinder and is provided with or not provided with the diffusion barrier layer 6a is filled between the outer cylinder and the inner cylinder with a plurality of the above complexes and subjected to pipe extrusion.

The Sn-based metal core 3 is inserted into the gap formed in the center of the pipe-like complex prepared by the above-described steps. The resultant complex is subjected to a diameter reduction process, thereby producing a precursor element shown in Fig. 1 or 2 that includes the Nb filaments 2 and the Sn-based metal core 3. Hereinafter, this precursor element is sometimes referred to as a "single-element wire".

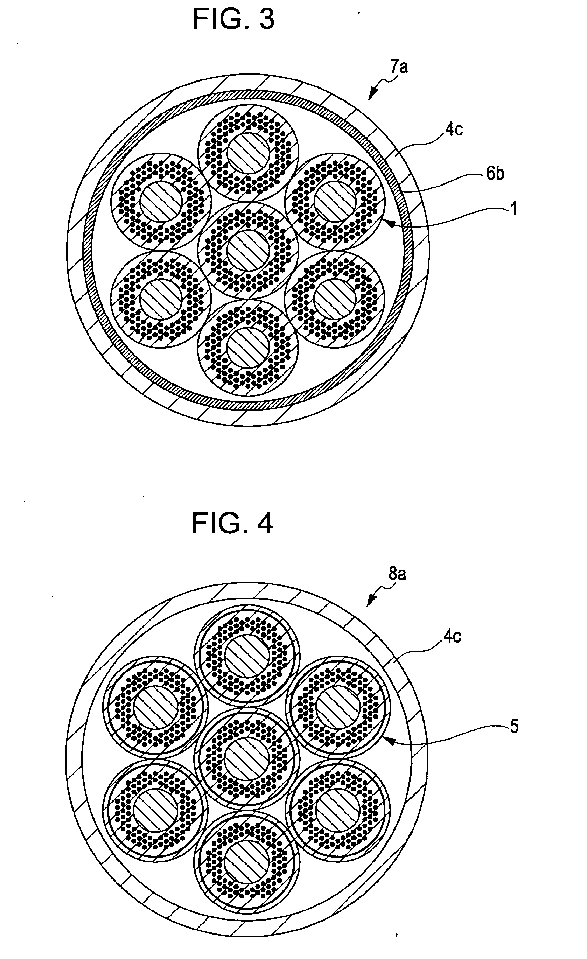

The resultant superconducting wire precursors (single-element wires 1 shown in Fig. 1) are bundled into an assembly and inserted into a Cu matrix tube provided with a diffusion barrier layer 6b (see Fig. 3 described below). The resultant superconducting wire precursors (single-element wires 5 shown in Fig. 2) are bundled into an assembly and inserted into a Cu matrix tube that is not provided with a diffusion barrier layer. In either case, the Cu matrix tube is subjected to a diameter reduction process to form a multi-core superconducting wire precursor (hereinafter, sometimes referred to as a "multi-element wire").

Figs. 3 and 4 illustrate examples of cross sections of multi-element wires prior to the wires being processed into superconducting wires. Specifically, Fig. 3 illustrates a multi-element wire 7a that is an assembly of a bundle of a plurality of the superconducting wire precursors 1 (single-element wires) shown in Fig. 1, the diffusion barrier layer 6b, and a Cu stabilizer layer 4c, the bundle being disposed inside of the diffusion barrier layer 6b and the Cu stabilizer layer 4c (for example, see "IEEE Transaction on Magnetics", Vol. MAG-19, No. 3, MAY 1983 p. 1131-1134). Fig. 4 illustrates a multi-element wire 8a that is an assembly of a bundle of a plurality of the precursors 5 (single-element wires) shown in Fig. 2 and the Cu stabilizer layer 4c, the bundle being disposed inside of the Cu stabilizer layer 4c without a diffusion barrier layer.

A supercurrent passes through a $Nb_3Sn$ phase, which is produced by subjecting a prepared superconducting wire precursor to a diffusion heat-treatment (typically 600°C to 700°C for about 100 to 300 hours). The $Nb_3Sn$ phase is extremely susceptible to mechanical distortion and a distortion of about just 1% results in a sharp decline in superconducting properties, in particular, critical current density Jc.

When $Nb_3Sn$ superconducting wires are used, almost all of the wires are in the superconducting magnetic state. In the superconducting magnetic state, wires are always subjected to electromagnetic forces caused by the magnetic fields of the magnets and currents passing through the magnets. In addition, in manufacturing of $Nb_3Sn$ superconducting wires, precursors are subjected to a heat treatment for producing a $Nb_3Sn$ phase at a high temperature of about 700°C while a current is passed through the wires at an extremely low temperature of 4.2 K or less. Thus, the $Nb_3Sn$ phase is also subjected to a force caused by thermal shrinkage of Cu disposed around the $Nb_3Sn$ phase. As a result, the $Nb_3Sn$ phase is distorted and its properties are degraded.

In an existing superconducting wire (multi-element wire) manufactured by an internal Sn process, in a cross section of the multi-element wire, single-element wires near the center of the multi-element wire and single-element wires near the circumference of the multi-element wire have different deformation states. Specifically, in both configurations in Figs. 3 and 4, the Nb filaments in the single-element wires near the center of the multi-element wire can be uniformly processed in wire drawing of the precursor. In contrast, the single-element wires near the circumference of the multi-element wire deform to fill in gaps formed between the single-element wires and the Cu tube or the diffusion barrier layer in the assembly of the precursor. This deformation of the single-element wires results in a nonuniform deformation of the Nb filaments disposed in the single-element wires. After the wire drawing, the Nb filaments disposed in outer positions of the multi-element wire tend to have large diameters.

When this nonuniform deformation happens, the distance between Nb and Sn required for producing $Nb_3Sn$ is increased in the circumference of the multi-element wire. This results in degradation of superconducting properties, in particular, critical current density Jc, which is a problem. The nonuniform deformation can also lead to a decrease in an n value required for NMR applications or to wire breakage during processing of the multi-element wire. The "n value" indicates uniformity of a current passing through a superconducting wire in the wire direction, that is, uniformity of superconducting filaments in the longitudinal direction of the wire. It is recognized that a superconducting wire having a larger n value has better superconducting properties, that is, uniformity of a current.

To reduce or prevent the degradation of critical current density Jc in a $Nb_3Sn$ superconducting wire, the strength of the wire needs to be enhanced by disposing proper reinforcing members in the wire. In view of enhancing the strength of a wire, a technique has been proposed in which a precursor is manufactured with a wire including $Al_2O_3$ diffused in a Cu stabilizer layer (for example, see "IEEE Transaction on Applied Superconductivity", Vol. 15, No. 2, June 2005 p. 1200-1204). Unfortunately, $Al_2O_3$ is very costly and use of $Al_2O_3$ is unfeasible.

Accordingly, it is an object of the present invention to provide a $Nb_3Sn$ superconducting wire manufactured by an internal Sn process, the wire having an enhanced mechanical strength and exhibiting good superconducting properties by enabling uniform processing in diameter reduction; and a precursor (superconducting wire precursor) for manufacturing such a $Nb_3Sn$ superconducting wire.

To achieve the object, the present invention provides a precursor for manufacturing a $Nb_3Sn$ superconducting

wire by an internal Sn process, including: a multi-element wire including a bundle of a plurality of single-element wires each including a Sn or Sn-based alloy core centrally disposed, and a Cu or Cu-based alloy matrix and a plurality of Nb or Nb-based alloy filaments surrounding the Sn or Sn-based alloy core; and a rod-like reinforcing member disposed in and/or around the bundle of the single-element wires.

In this precursor for manufacturing a $Nb_3Sn$ superconducting wire according to the present invention, for example, the following features are preferred: (a) a configuration where the reinforcing member has a smaller diameter than the single-element wires; (b) a configuration where the rod-like reinforcing member includes a core composed of a metal or an alloy including Nb and/or Ta and a Cu or Cu-based alloy layer surrounding the core; (c) a configuration where the rod-like reinforcing member includes a core composed of a metal or an alloy including Nb and/or Ti, a diffusion barrier layer composed of Nb and surrounding the core, and a Cu or Cu-based alloy layer surrounding the diffusion barrier layer; (d) a configuration where a cross-sectional area of the reinforcing member accounts for 2% to 25% of a cross-sectional area of the precursor; and (e) a configuration where the Cu or Cu-based alloy layer present at a surface of the reinforcing member has a copper ratio of 0.1 to 1.0 relative to the reinforcing member prior to wire drawing.

In a precursor for manufacturing a $Nb_3Sn$ superconducting wire according to the present invention, a diffusion barrier layer may be disposed near circumferences of the single-element wires and/or near a circumference of the multi-element wire.

$Nb_3Sn$ superconducting wires that exhibit desired superconducting properties (critical current density Jc and strength) can be manufactured by an internal Sn process in which the above precursors for manufacturing superconducting wires are subjected to a diffusion heat-treatment.

The present invention can provide a superconducting wire maintaining good superconducting properties and having sufficiently high strength by employing a superconducting wire precursor (multi-element wire) for manufacturing a $Nb_3Sn$ superconducting wire by an internal Sn process, the precursor having a configuration including a rod-like reinforcing member disposed in and/or around the bundle of single-element wires.

Fig. 1 is a schematic section view of a configuration example of a superconducting wire precursor (single-element wire) for an internal Sn process;

Fig. 2 is a schematic section view of another configuration example of a superconducting wire precursor (single-element wire) for an internal Sn process;

Fig. 3 is a schematic section view of a configuration example of a superconducting wire precursor (multi-element wire) for an internal Sn process prior to wire drawing;

Fig. 4 is a schematic section view of another configuration example of a superconducting wire precursor (multi-element wire) for an internal Sn process prior to wire drawing;

Fig. 5 is a schematic section view showing the inner state of the superconducting wire precursor (multi-element wire) shown in Fig. 3 after being subjected to wire drawing;

Fig. 6 is a schematic section view showing the inner state of the superconducting wire precursor (multi-element wire) shown in Fig. 4 after being subjected to wire drawing;

Fig. 7 is a schematic explanatory view showing a section of a configuration example of a reinforcing member;

Fig. 8 is a schematic explanatory view showing a section of another configuration example of a reinforcing member;

Fig. 9 is a schematic section view of a configuration example of a superconducting wire precursor according to the present invention;

Fig. 10 is a schematic section view showing the inner state of the superconducting wire precursor (multi-element wire) shown in Fig. 9 after being subjected to wire drawing;

Fig. 11 is a schematic section view of another configuration example of a precursor according to the present invention;

Fig. 12 is a schematic section view showing the inner state of the superconducting wire precursor (multi-element wire) shown in Fig. 11 after being subjected to wire drawing;

Fig. 13 is a schematic section view of still another configuration example of a superconducting wire precursor according to the present invention;

Fig. 14 is a schematic section view showing the inner state of the superconducting wire precursor (multi-element wire) shown in Fig. 13 after being subjected to wire drawing;

Fig. 15 is a schematic section view of still another configuration example of a superconducting wire precursor according to the present invention; and

Fig. 16 is a schematic section view showing the inner state of the superconducting wire precursor (multi-element wire) shown in Fig. 15 after being subjected to wire drawing.

DESCRIPTION OF THE PREFERRED EMBODIMENTS

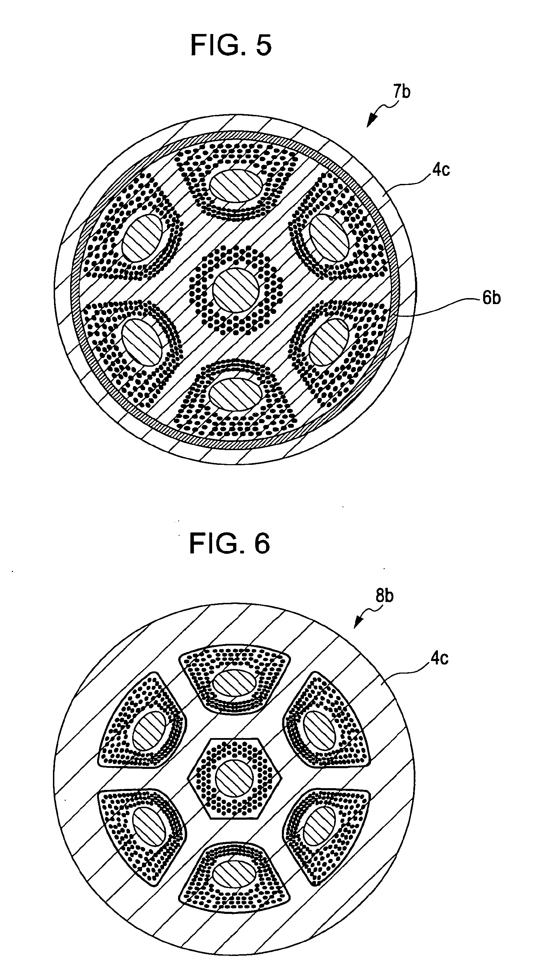

When an existing precursor is subjected to wire drawing, deformation state in the precursor differs in the radius direction. This is described with reference to drawings. Fig. 5 is a section view showing the inner state of a superconducting wire precursor 7b obtained by subjecting the superconducting wire precursor 7a shown in Fig. 3 to wire drawing. Fig. 6 is a section view showing the inner state of a superconducting wire precursor 8b obtained by subjecting the superconducting wire precursor 8a shown in Fig. 4 to wire drawing. As shown in the superconducting wire precursors (multi-element wires) 7b and 8b in these drawings, Nb filaments (cores 2 composed of Nb or a Nb-based alloy) in single-element wires disposed near the center of the multi-element wires can be uniformly processed in wire drawing. In contrast, single-element wires near the circumferences of the multi-element wires deform to fill in gaps formed in assembly of the precursor. As a result, these single-element wires near the circumferences are distorted, and hence, Nb filaments in these single-element wires are distributed nonuniformly in cross sections of the multi-element wires.

When this nonuniform deformation shown in Figs. 5 and 6 happens, Nb filaments near the circumferences of the multi-element wires 7b and 8b account for relatively large areas, and hence, Sn is required to diffuse over large distances to produce $Nb_3Sn$ in a diffusion heat-treatment. For this reason, $Nb_3Sn$ is not sufficiently produced, resulting in a decrease in critical current density Jc and a decrease in the n value. In the multi-element wires 7b and 8b, distortion caused by processing is localized and occurrence of wire breakage is highly likely during a diameter reduction process such as extrusion or wire drawing. Superconducting wires obtained by an internal Sn process in which such superconducting wire precursors are heat-treated have low critical current density Jc and low n values. In particular, such superconducting wires can have much lower n values than superconducting wires obtained by a bronze process.

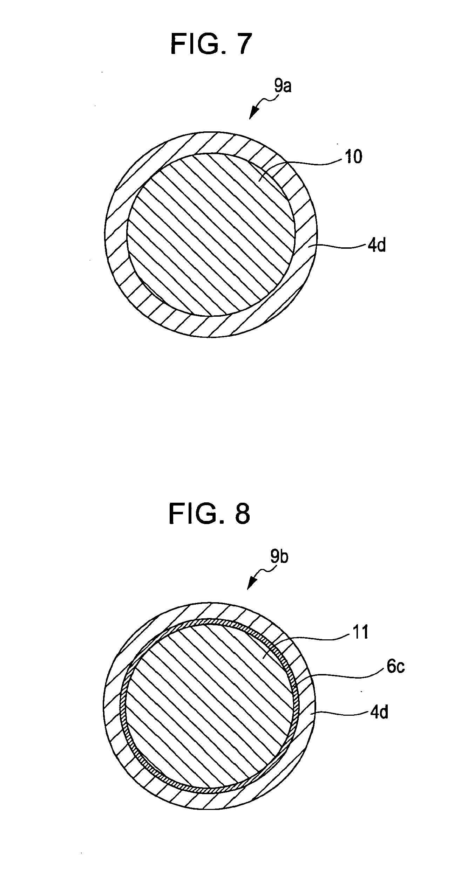

The configurations of superconducting wire precursors according to the present invention are described with reference to drawings. In superconducting wire precursors according to the present invention, multi-element wires like those shown in Figs. 3 and 4 (7a in Fig. 3, 8a in Fig. 4) are configured to include reinforcing members disposed in gaps in the wires, thereby enhancing the strength of the superconducting wires and enabling uniform processing of Nb filaments.

Fig. 7 is a schematic explanatory view showing the configuration of a reinforcing member according to the present invention. A reinforcing member 9a has a rod-like appearance. The reinforcing member 9a includes a core 10 centrally disposed and composed of Nb, a Nb-Ta alloy, or Ta and a Cu or Cu-based alloy layer 4d surrounding the core 10.

Fig. 8 is a schematic explanatory view showing another configuration example of a reinforcing member according to the present invention. A reinforcing member 9b is basically similar to the configuration shown in Fig. 7 in that the reinforcing member 9b has a rod-like appearance and includes a core 11 centrally disposed and composed of Ti or a Nb-Ti alloy and the Cu or Cu-based alloy layer 4d disposed at the outermost of the reinforcing member 9b. However, when the core 11 is composed of a metal or an alloy containing Ti, a reaction between Ti and Cu occurs in a reduction process or annealing to produce a brittle Cu-Ti compound, which increases the possibility of breakage of the reinforcing member. To avoid this disadvantage, the reinforcing member 9b further includes a diffusion barrier layer 6c composed of Nb between the Cu or Cu-based alloy layer 4d and the core 11 composed of a metal or an alloy containing Ti. In the configuration of the reinforcing member 9b, Cu and Ti are not in direct contact with each other. This configuration suppresses generation of the brittle Cu-Ti compound, thereby preventing the occurrence of disadvantages such as breakage of the reinforcing member.

The diffusion barrier layer 6c should suppress the generation of the compound caused by application of heat in a short period of time in extrusion or processing. On the other hand, in view of providing sufficient strength to a superconducting wire, it is preferred that the diffusion barrier layer 6c does not considerably inhibit diffusion of Cu into Ti in the subsequent diffusion heat-treatment. Thus, the Nb diffusion barrier layer 6c preferably has a thickness of about 0.2% to 2% of the diameter of the core 11. The ratio of the Cu outer layer (Cu or Cu-based alloy layer 4d) to the reinforcing member is preferably, in view of workability and strength (reinforcing effect of the core), about 0.1 to 1.0 in terms of a copper ratio (area ratio of copper portions to non-copper portions) of the reinforcing member prior to wire drawing. More preferably, the copper ratio is about 0.3 to 0.6.

According to the present invention, a precursor similar to that (multi-element wire 7a or 8a) in Fig. 3 or 4 is configured to further include the rod-like reinforcing member(s) 9a or 9b (hereinafter, referred to as "9a, 9b") shown in Fig. 7 or 8 disposed in and/or around the bundle of single-element wires. The term "rod-like" (rod-like reinforcing member) refers to a shaft having the shape of a cylinder, a prism, or a column deformed to some extent. A multi-element wire includes a plurality of reinforcing members. Although these reinforcing members in a multi-element wire may be composed of materials different from one another, in view of achieving balance in processing, the reinforcing members are preferably composed of an identical material or identical materials.

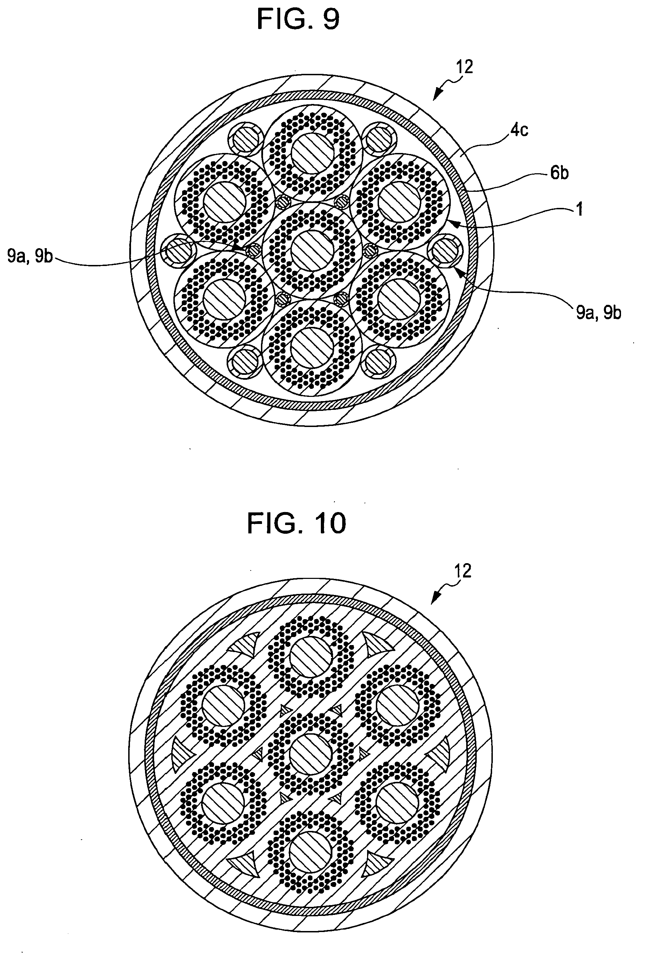

Fig. 9 is a schematic explanatory view showing a configuration example of a superconducting wire precursor (multi-element wire) according to the present invention. This configuration is basically similar to that of the multi-element wire in Fig. 3 and features common to both drawings are designated with identical reference numerals. In Fig. 9, a multi-element wire 12 is constituted by combining the single-element wires 1 (without a diffusion barrier layer) shown in Fig. 1 and the reinforcing members 9a, 9b shown in Figs. 7 and 8.

Specifically, in the superconducting wire precursor shown in Fig. 9, a multi-element wire similar to that in Fig. 3 is constituted by a bundle of the single-element wires 1 in Fig. 1 and the reinforcing members 9a, 9b disposed in the bundle of the single-element wires 1 or around the bundle of the single-element wires 1 (that is, between the diffusion barrier layer 6b and the single-element wires 1). In this configuration, the reinforcing members 9a, 9b deform in processing such as wire drawing so as to conform to gaps in the multi-element wire. As a result, distortion can be reduced in deformation of the single-element wires 1 present near the circumference of the multi-element wire. Also, the resultant superconducting wire has a high strength and enhanced resistance to distortion. Fig. 10 schematically shows the inner state of the superconducting wire precursor shown in Fig. 9 after being subjected to wire drawing.

In the configuration shown in Fig. 9, the reinforcing members 9a, 9b are disposed in the bundle of the single-element wires 1 and around the bundle of the single-element wires 1 (that is, between the diffusion barrier layer 6b and the bundle of the single-element wires 1). Alternatively, the reinforcing members 9a, 9b may be disposed either in or around the bundle of the single-element wires 1.

In the configuration shown in Fig. 9, the reinforcing members 9a, 9b disposed around the bundle of the single-element wires 1 are larger in terms of their cross-sections than the reinforcing members 9a, 9b disposed in the bundle of the single-element wires 1. Alternatively, the reinforcing members 9a, 9b disposed around the bundle of the single-element wires 1 may be smaller in terms of their cross-sections than the reinforcing members 9a, 9b disposed in the bundle of the single-element wires 1. As for the sizes of the reinforcing members 9a, 9b and the single-element wires 1, in view of disposing the reinforcing members 9a, 9b in gaps of a precursor in the assembly of the precursor according to the present invention, the reinforcing members 9a, 9b are preferably smaller than the single-element wires 1. For example, the reinforcing members 9a, 9b have diameters that are less than and 0.1 or more times those of the single-element wires 1.

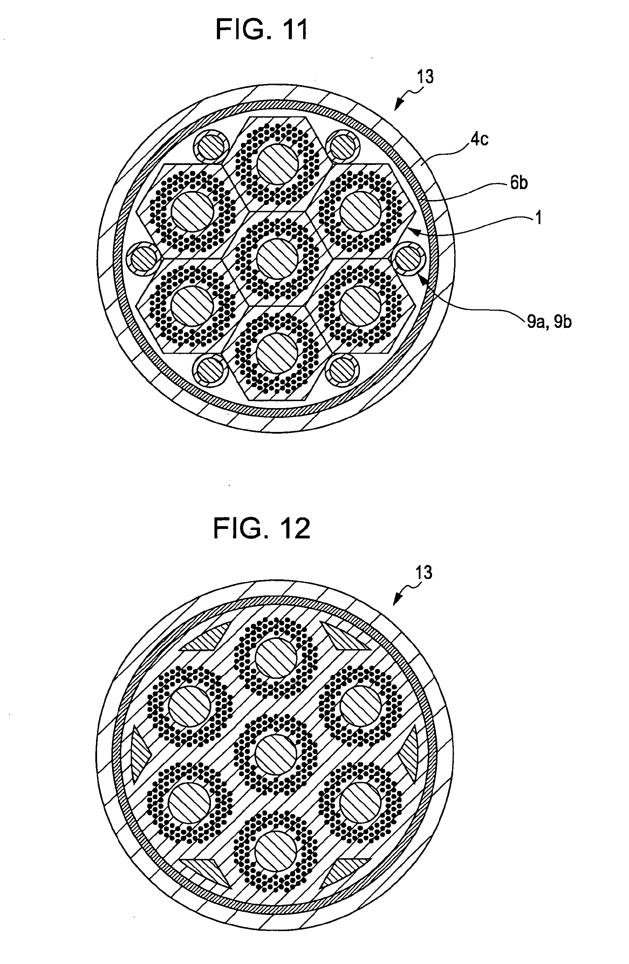

Fig. 11 is a schematic explanatory view showing another configuration example of a precursor according to the present invention. In this configuration, the multi-element wire includes a bundle of the single-element wires 1 shown in Fig. 1 and the reinforcing members 9a, 9b disposed only around the bundle of the single-element wires 1 (that is, between the diffusion barrier layer 6b and the single-element wires 1). Specifically, in the configuration of Fig. 11, a multi-element wire 13 is constituted by a bundle of the single-element wires 1 having hexagonal cross-sections (sections perpendicular to the axes of the wires 1), which facilitate bundling of the single-element wires 1. When such single-element wires 1 are bundled, gaps into which reinforcing members can be inserted are not generally formed in the bundle of the single-element wires 1. For this reason, the reinforcing members are disposed only around the bundle of the single-element wires 1. In this configuration, each reinforcing member is disposed between two neighboring single-element wires and the diffusion barrier layer. As a whole, the reinforcing members are disposed at equal intervals and in a substantially circular pattern.

Also in this configuration, distortion can be reduced in deformation of the single-element wires 1 present near the circumference of the multi-element wire. The resultant superconducting wire has a high strength and enhanced resistance to distortion. Fig. 12 schematically shows the inner state of the superconducting wire precursor shown in Fig. 11 after being subjected to wire drawing.

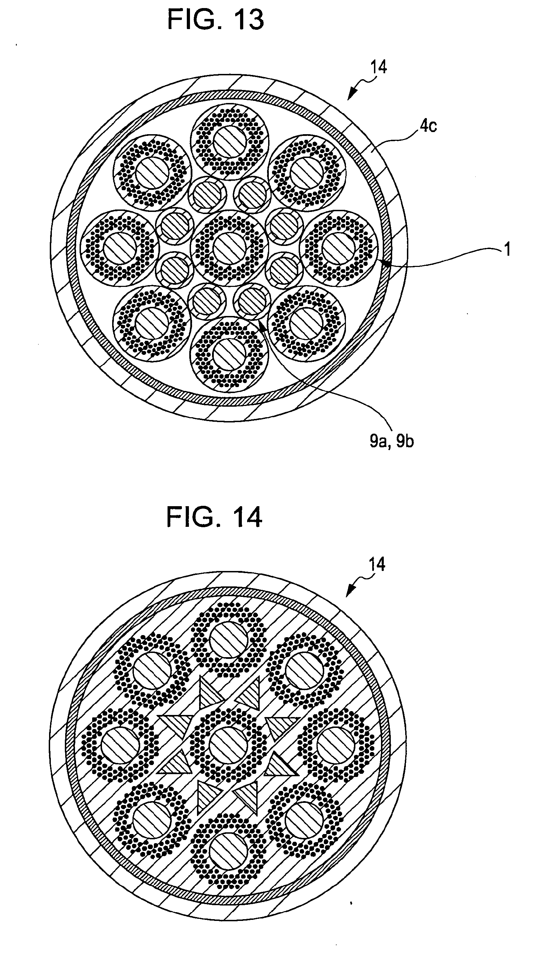

Fig. 13 is a schematic explanatory view showing still another configuration example of a superconducting wire precursor according to the present invention. In this configuration, a multi-element wire 14 similar to that in Fig. 3 is constituted by a bundle of the single-element wires 1 shown in Fig. 1 and the reinforcing members 9a, 9b not disposed around the bundle of the single-element wires 1 but disposed only in the gap in the bundle of the single-element wires 1. With this configuration, objects of the present invention can be also achieved. Fig. 14 schematically shows the inner state of the superconducting wire precursor shown in Fig. 13 after being subjected to wire drawing. In this configuration, each reinforcing member is disposed between two neighboring single-element wires and the centrally disposed single-element wire. As a whole, the reinforcing members are disposed at equal intervals and in a substantially circular pattern.

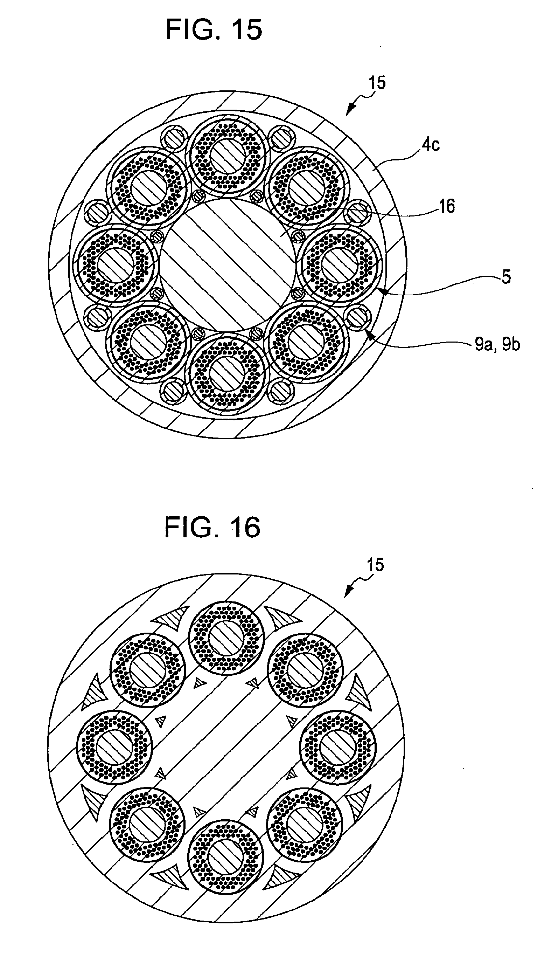

In the superconducting wire precursors (multi-element wires) shown in Figs. 3 and 4, Cu or Cu-based alloy cores may be disposed in the centers of the multi-element wires for achieving required critical current density Jc. Fig. 15 is a schematic explanatory view showing a configuration example, basically similar to these configurations, of a superconducting wire precursor according to the present invention. Specifically, in a superconducting wire precursor 15 shown in Fig. 15, a multi-element wire similar to a multi-element wire 8a in Fig. 4 is constituted by a Cu or Cu-based alloy core 16 disposed in the center of the precursor, the single-element wires 5 in Fig. 2 surrounding the Cu or Cu-based alloy core 16, and the reinforcing members 9a, 9b disposed in the bundle of the single-element wires 5 (among the single-element wires 5 and the Cu or Cu-based alloy core 16) and around the bundle of the single-element wires 5 (that is, between the Cu stabilizer layer 4c and the single-element wires 5). With this configuration, objects of the present invention can be also achieved. Fig. 16 schematically shows the inner state of the superconducting wire precursor 15 shown in Fig. 15 after being subjected to wire drawing.

The multi-element wires 12, 13, 14, and 15 according to the present invention are constituted by the single-element wires 1, 5 shown in Figs. 1 and 2 and the reinforcing members 9a, 9b shown in Figs. 7 and 8. In these configurations, nonuniform deformation of the single-element wires 1, 5 is prevented while Nb filaments in the single-element wires 1, 5 have uniform sizes and high critical current density Jc and high n values can be achieved. The reinforcing members 9a, 9b according to the present invention are preferably preannealed prior to incorporation into a superconducting wire precursor. Specifically, the reinforcing members 9a, 9b preannealed at about 500°C to 900°C are incorporated into a multi-element wire as its constituents. In this configuration, the reinforcing members 9a, 9b being subjected to diameter reduction tend to deform so as to conform to gaps in the bundle of the single-element wires 1, 5 and/or gaps among the single-element wires 1, 5 and the diffusion barrier layer 6b or the Cu stabilizer layer 4c. As a result, the single-element wires 1, 5 are deformed uniformly and Nb filaments in the single-element wires 1, 5 are also deformed uniformly. This provides high critical current density Jc and a high n value and wire breakage occurring in diameter reduction is also reduced.

Disposition of reinforcing members in a multi-element wire reduces the area of superconducting portion ($Nb_3Sn$ phase), thereby decreasing critical current density Jc. For this reason, enhancement of the strength of a multi-element wire by increasing the ratio of the reinforcing members 9a, 9b has its limitation. In contrast, it is difficult to achieve the objects when the ratio of the reinforcing members 9a, 9b is too small. In summary, the cross-sectional area of the reinforcing members preferably account for about 2% to 25% of the cross-sectional area of a precursor.

In manufacturing of a superconducting wire precursor according to the present invention, a Cu-based alloy used for manufacturing single-element wires or for covering the cores of the reinforcing members may contain about 2% to 5% by mass of an alloy element such as Sn or Ni. The Sn-based alloy cores disposed at the centers of the single-element wires may be composed of a Sn-based alloy containing about 2% by mass of an alloy element such as Ti.

According to the present invention, $Nb_3Sn$ superconducting wires exhibiting a good superconducting property (critical current density Jc) can be obtained by subjecting the above-described precursors to a diffusion heat-treatment (generally about 600°C or more and 700°C or less) including a heat treatment for producing bronze. Specifically, a heat treatment for producing bronze (diffusing Sn into Cu) is conducted in the temperature range of 180°C to 600°C and subsequently a heat treatment for producing $Nb_3Sn$ is conducted in the temperature range of 600°C to 700°C for about 100 to 300 hours. The heat treatment for producing bronze may be constituted by multistep heat treatment, for example, that includes a step at 180°C to 200°C for about 50 hours, a step at about 340°C for about 50 hours, and a step at about 550°C for about 50 to 100 hours.

Hereinafter, the present invention is described in further detail with reference to Examples. However, the present invention is not restricted to Examples below. It is apparent to those skilled in the art that various changes and modifications can be made without departing from the spirit described in the specification. The present invention is intended to embrace such changes and modifications.

EXAMPLES

Example 1

Cu/Nb composite wires having a hexagonal section (opposite side distance of the hexagon: 4.3 mm), Cu/Nb composite wires having a circular section (diameter: 3.2 mm), and Cu/Nb composite wires having a circular section (diameter: 1.4 mm) were manufactured by inserting Nb metal cores (diameter: 17 mm) into Cu pipes (outer diameter: 21 mm, inner diameter: 18 mm) and subjecting the resultant pipes to a diameter reduction process. The Cu/Nb composite wires having circular sections were annealed in vacuum at 600°C for an hour and cut.

A Cu hollow billet including a Cu outer cylinder having an outer diameter of 143 mm and an inner diameter of 131 mm and a Cu inner cylinder having an outer diameter of 70 mm and an inner diameter of 61 mm was prepared. A bundle of 511 Cu/Nb composite wires having a hexagonal section described above was provided around the Cu inner cylinder and inserted into the Cu outer cylinder. The resulting billet was covered and evacuated, followed by welding of the covers at the both ends of the billet. The resulting billet was subjected to pipe extrusion. A Sn alloy core containing 2% by mass Ti was inserted through the Cu inner cylinder. The resulting billet was subjected to wire drawing and cutting to form single-element wires having an outer diameter of 8.8 mm.

A Nb sheet having a thickness of 0.1 mm was rolled back on itself several times to form a cylinder with a thickness of 0.7 mm. This cylinder was inserted into a Cu pipe having an outer diameter of 33 mm and an inner diameter of 29 mm and attached to the inner surface of the Cu pipe. A bundle of seven single-element wires described above were inserted into the Cu pipe. Six Cu/Nb composite wires having a 1.4 mm diameter circular section described above were inserted into gaps in the bundle of the single-element wires. Six Cu/Nb composite wires having a 3.2 mm diameter circular section described above were inserted into gaps among the Nb sheet and the single-element wires. The resultant pipe was subjected to a diameter reduction process to form a multi-element wire having an outer diameter of 1.0 mm (see Fig. 10). The reinforcing members (Cu/Nb composite wires) had a copper ratio of 0.35 and a cross-sectional area ratio of 9%. The term "cross-sectional area ratio" refers to a ratio of the cross-sectional area of the reinforcing members to the cross-sectional area of the precursor in the specification.

The resultant multi-element wire having a diameter of 1.0 mm was subjected to a heat treatment for producing $Nb_3Sn$ (at 550°C for 100 hours and at 700°C for 100 hours). After that, the resultant sample was evaluated in terms of critical current density Jc and an n value by the following methods. The sample was subjected to a tensile test with being immersed in liquid helium at 4.2 K to measure the 0.2% proof stress ($\sigma_{0.2}$) of the sample. The sample was also evaluated in terms of the number of wire breakage during wire drawing. The critical current density Jc should be 1000 A/mm$^2$ or

more when an external magnetic field of 14 T is applied. The 0.2% proof stress ($\sigma_{0.2}$) should be 150 MPa or more.

Measurement of critical current density Jc

An electric current was passed through the sample (superconducting wire) in liquid helium at a temperature of 4.2 K under an external magnetic field of 14 T to measure a generated voltage by a four-terminal method. When an electrical field of 0.1 $\mu$V/cm was produced, an electric current (critical current Ic) was measured. This measured current value was divided by the entire sectional area of non-copper portions of the wire to determine the critical current density Jc of the non-copper portions.

Measurement of n value

In an (Ic-Vc) curve obtained by the same measurement as in determining of the critical current Ic, data between 0.1 $\mu$V and 1.0 $\mu$V was indicated in a log-log graph, and an n value was obtained from the gradient of the graph. A relationship between the current Ic and the voltage Vc can be empirically expressed by the following approximate expression (1). The n value was determined according to this expression (1).

$$V = Vc(I/Ic)^n \quad (1)$$

In the expression, V is a voltage lower than Vc and I is an electric current lower than Ic.

Example 2

Cu/Nb composite wires having a hexagonal section (opposite side distance of the hexagon: 4.3 mm) were manufactured by inserting Nb metal cores (diameter: 17 mm) into Cu pipes (outer diameter: 21 mm, inner diameter: 18 mm) and subjecting the resultant pipes to a diameter reduction process.
Cu/Nb/Nb-Ti composite wires having a circular section (diameter: 2.7 mm) and Cu/Nb/Nb-Ti composite wires having a circular section (diameter: 1.1 mm) were manufactured by the following method. A Cu billet having an outer diameter of 143 mm and an inner diameter of 120 mm was prepared. A Nb sheet having a thickness of 0.2 mm was rolled back on itself several times to form a cylinder. The resultant cylinder was inserted into the Cu billet and attached to the inner surface of the Cu billet. A Nb alloy core containing 47% by mass Ti was inserted into the Cu billet. The resultant Cu billet was subjected to extrusion and wire drawing. The resultant composite wires having circular sections were annealed in vacuum at 600°C for an hour and cut.
A Cu hollow billet including a Cu outer cylinder having an outer diameter of 143 mm and an inner diameter of 131 mm and a Cu inner cylinder having an outer diameter of 70 mm and an inner diameter of 61 mm was prepared. A Nb sheet was rolled back on itself several times to form a cylinder. The resultant cylinder was inserted into the Cu hollow billet and attached to the inner surface of the Cu hollow billet to form a diffusion barrier layer. A bundle of 456 Cu/Nb composite wires having a hexagonal section described above was provided around the Cu inner cylinder and inserted into the Cu outer cylinder. The resulting billet was covered and evacuated, followed by welding of the covers at the both ends of the billet. The resulting billet was subjected to pipe extrusion. A Sn alloy core containing 2% by mass Ti was inserted through the Cu inner cylinder. The resulting billet was subjected to wire drawing and cutting to form single-element wires having an outer diameter of 7.4 mm.
A Cu pipe having an outer diameter of 33 mm and an inner diameter of 29 mm was prepared. A bundle of eight single-element wires described above surrounding a Cu core having a diameter of 11.5 mm was inserted into the Cu pipe. Eight Cu/Nb/Nb-Ti composite wires having a 1.1 mm diameter circular section described above were inserted into gaps among the single-element wires and the Cu core. Eight Cu/Nb/Nb-Ti composite wires having a 2.7 mm diameter circular section described above were inserted into gaps among the single-element wires and the Cu pipe (see Fig. 15). The resultant pipe was subjected to a diameter reduction process to form a multi-element wire having an outer diameter of 1.0 mm. The reinforcing members (Cu/Nb/Nb-Ti composite wires) had a copper ratio of 0.55 and a cross-sectional area ratio of 8%.
The resultant multi-element wire having a diameter of 1.0 mm was subjected to a heat treatment for producing Nb$_3$Sn (at 550°C for 100 hours and at 700°C for 100 hours). After that, as in Example 1, the resultant sample was evaluated in terms of critical current density Jc, an n value, and 0.2% proof stress ($\sigma_{0.2}$).

Example 3

As in Example 1, single-element wires having a diameter of 7.5 mm and Cu/Nb composite wires having a circular section with an outer diameter of 3.2 mm were manufactured. The Cu/Nb composite wires were annealed in vacuum at 600°C for an hour and cut.

A Cu pipe having an outer diameter of 33 mm and an inner diameter of 29 mm was prepared. A Nb sheet with a thickness of 0.2 mm was rolled back on itself several times to form a cylinder and inserted into the Cu pipe so as to be attached to the inner surface of the Cu pipe. One of the single-element wires described above was disposed in the center of the Cu pipe. A bundle of eight single-element wires described above was inserted into the Cu pipe so as to surround the centrally-disposed single-element wire. Eight Cu/Nb composite wires having a circular section described above were inserted into gaps among the single-element wires (see Fig. 13). The resultant pipe was subjected to a diameter reduction process to form a multi-element wire having an outer diameter of 1.0 mm. The reinforcing members (Cu/Nb composite wires) had a copper ratio of 0.35 and a cross-sectional area ratio of 10%.

The resultant multi-element wire having a diameter of 1.0 mm was subjected to a heat treatment for producing $Nb_3Sn$ (at 550°C for 100 hours and at 700°C for 100 hours). After that, as in Example 1, the resultant sample was evaluated in terms of critical current density Jc, an n value, and 0.2% proof stress ($\sigma_{0.2}$).

Example 4

As in Example 1, single-element wires having a hexagonal section (opposite side distance of the hexagon: 3.2 mm) and Cu/Nb composite wires having a circular section with an outer diameter of 4 mm were manufactured. The Cu/Nb composite wires were annealed in vacuum at 600°C for an hour and cut.

A Cu pipe having an outer diameter of 33 mm and an inner diameter of 29 mm was prepared. A Nb sheet with a thickness of 0.2 mm was rolled back on itself several times to form a cylinder and inserted into the Cu pipe so as to be attached to the inner surface of the Cu pipe. A bundle of seven single-element wires described above was inserted into the Cu pipe. Six Cu/Nb composite wires having a circular section described above were inserted into gaps among the single-element wires and the Nb sheet (see Fig. 11). The resultant pipe was subjected to a diameter reduction process to form a multi-element wire having an outer diameter of 1.0 mm. The reinforcing members (Cu/Nb composite wires) had a copper ratio of 0.34 and a cross-sectional area ratio of 9.5%.

The resultant multi-element wire having a diameter of 1.0 mm was subjected to a heat treatment for producing $Nb_3Sn$ (at 550°C for 100 hours and at 700°C for 100 hours). After that, as in Example 1, the resultant sample was evaluated in terms of critical current density Jc, an n value, and 0.2% proof stress ($\sigma_{0.2}$).

Comparative Example 1

Single-element wires were manufactured and a multi-element wire having an outer diameter of 1.0 mm was manufactured as in Example 1 except that the Cu/Nb composite wires were not inserted as spacers (reinforcing members) (see Figs. 3 and 5). The resultant multi-element wire having a diameter of 1.0 mm was subjected to a heat treatment for producing $Nb_3Sn$ (at 550°C for 100 hours and at 700°C for 100 hours). After that, as in Example 1, the resultant sample was evaluated in terms of critical current density Jc, an n value, and 0.2% proof stress ($\sigma_{0.2}$).

Comparative Example 2

Single-element wires having an outer diameter of 8.8 mm were manufactured and cut as in Example 2. A bundle of seven single-element wires described above was inserted into a Cu pipe having an outer diameter of 33 mm and an inner diameter of 29 mm. The resultant pipe was subjected to a diameter reduction process to form a multi-element wire having an outer diameter of 1.0 mm (see Figs. 4 and 6). The resultant multi-element wire having a diameter of 1.0 mm was subjected to a heat treatment for producing $Nb_3Sn$ (at 550°C for 100 hours and at 700°C for 100 hours). After that, as in Example 1, the resultant sample was evaluated in terms of critical current density Jc, an n value, and 0.2% proof stress ($\sigma_{0.2}$).

Table 1 below shows measurement results of the superconducting wires in Examples 1 to 4 and Comparative Examples 1 and 2 in terms of superconducting properties (critical current density Jc and an n value), a mechanical property [0.2% proof stress ($\sigma_{0.2}$)], and the number of wire breakage during wire drawing. For reference, Table 1 also shows the superconducting properties and the mechanical property of a typical superconducting wire manufactured by a bronze process under manufacturing conditions in the case of using Cu containing 14% by mass Sn and 0.3% by mass Ti.

[Table 1]

| | Critical current density Jc (A/mm$^2$) | n value | 0.2% proof stress ($\sigma_{0.2}$) (MPa) | Number of wire breakage |
|---|---|---|---|---|
| Example 1 | 1102 | 50 | 179 | 0 |
| Example 2 | 1305 | 49 | 181 | 0 |
| Example 3 | 1050 | 47 | 188 | 0 |
| Example 4 | 1022 | 46 | 190 | 0 |
| Comparative Example 1 | 1070 | 32 | 143 | 1 |
| Comparative Example 2 | 1285 | 35 | 147 | 2 |
| Bronze process | 340 | 48 | 183 | 0 |

As is evident from these results, each of the samples of Examples 1 to 4 according to the present invention achieves good superconducting properties (an n value and critical current density Jc) and exhibits a 0.2% proof stress ($\sigma_{0.2}$) of 150 MPa or more.

In contrast, each of the samples of Comparative Examples 1 and 2, in which reinforcing members were not incorporated, has a low 0.2% proof stress ($\sigma_{0.2}$) at 4.2 K. The sample obtained by a bronze process exhibits a good n value and a good 0.2% proof stress ($\sigma_{0.2}$), but exhibits a low critical current density Jc.

In the Examples, reinforcing members composed of Cu-Nb or Cu/Nb/Nb-Ti were used. Alternatively, reinforcing members composed of Ta or Nb-Ta may be used.

**Claims**

1. A precursor for manufacturing a Nb$_3$Sn superconducting wire by an internal Sn process, comprising:

   a multi-element wire including:

      a bundle of a plurality of single-element wires each including a Sn or Sn-based alloy core centrally disposed, and a Cu or Cu-based alloy matrix and a plurality of Nb or Nb-based alloy filaments surrounding the Sn or Sn-based alloy core; and
      a rod-like reinforcing member disposed in and/or around the bundle of the single-element wires.

2. The precursor for manufacturing a Nb$_3$Sn superconducting wire by an internal Sn process according to Claim 1, wherein the reinforcing member has a smaller diameter than the single-element wires.

3. The precursor for manufacturing a Nb$_3$Sn superconducting wire by an internal Sn process according to Claim 1 or 2, wherein the reinforcing member includes a core composed of a metal or an alloy including Nb and/or Ta and a Cu or Cu-based alloy layer surrounding the core.

4. The precursor for manufacturing a Nb$_3$Sn superconducting wire by an internal Sn process according to Claim 1 or 2, wherein the reinforcing member includes a core composed of a metal or an alloy including Nb and/or Ti, a diffusion barrier layer composed of Nb and surrounding the core, and a Cu or Cu-based alloy layer surrounding the diffusion barrier layer.

5. The precursor for manufacturing a Nb$_3$Sn superconducting wire by an internal Sn process according to any one of Claims 1 to 4, wherein a cross-sectional area of the reinforcing member accounts for 2% to 25% of a cross-sectional area of the precursor.

6. The precursor for manufacturing a Nb$_3$Sn superconducting wire by an internal Sn process according to any one of Claims 3 to 5, wherein the Cu or Cu-based alloy layer present at a surface of the reinforcing member has a copper ratio of 0.1 to 1.0 relative to the reinforcing member prior to wire drawing.

**7.** The precursor for manufacturing a Nb$_3$Sn superconducting wire by an internal Sn process according to any one of Claims 1 to 6, wherein the reinforcing member is preannealed in the temperature range of 500°C to 900°C.

**8.** The precursor for manufacturing a Nb$_3$Sn superconducting wire by an internal Sn process according to any one of Claims 1 to 7, wherein a diffusion barrier layer is disposed near circumferences of the single-element wires and/or near a circumference of the multi-element wire.

**9.** A Nb$_3$Sn superconducting wire manufactured by an internal Sn process, comprising a Nb$_3$Sn superconducting phase formed by subjecting the precursor according to any one of Claims 1 to 8 to a diffusion heat-treatment.

# FIG. 1

# FIG. 2

# FIG. 3

# FIG. 4

# FIG. 5

# FIG. 6

# FIG. 7

9a

10

4d

# FIG. 8

9b

11

6c

4d

# FIG. 9

# FIG. 10

# FIG. 11

# FIG. 12

# FIG. 13

# FIG. 14

## FIG. 15

## FIG. 16

Europäisches
Patentamt

European
Patent Office

Office européen
des brevets

# EUROPEAN SEARCH REPORT

**Application Number**

EP 09 00 2671

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | PANTSYRNYI V ET AL: "Nb3Sn Superconducting Wire, Reinforced by Cu-Nb Microcomposite Material" IEEE TRANSACTIONS ON APPLIED SUPERCONDUCTIVITY, IEEE SERVICE CENTER, LOS ALAMITOS, CA, US, vol. 14, no. 2, 1 June 2004 (2004-06-01), pages 996-999, XP011117510 ISSN: 1051-8223 * page 996, column 2, paragraphs 1,2 * * page 997, column 1, paragraphs 1,3 * * page 999, column 1, paragraph 3 * * figures 1a,3a; table III * ----- | 1-5,7-9 | INV. H01L39/24 |
| Y | US 5 127 149 A (OZERYANSKY GENNADY [US]) 7 July 1992 (1992-07-07) * column 1, lines 30-45 * * column 2, lines 31-35 * ----- | 1-5,7-9 | |
| Y | US 2007/186998 A1 (KATO HIROYUKI [JP] ET AL) 16 August 2007 (2007-08-16) * paragraph [0009] * ----- | 1 | |
| Y | SAKAMOTO H ET AL: "(Nb,Ti)3Sn superconducting wire reinforced with Nb-Ti-Cu compound" IEEE TRANSACTIONS ON APPLIED SUPERCONDUCTIVITY IEEE USA, vol. 10, no. 1, March 2000 (2000-03), pages 1008-1011, XP002525325 ISSN: 1051-8223 * page 1008, column 2, paragraphs 1,3; figure 1 * ----- | 3,4,7 | TECHNICAL FIELDS SEARCHED (IPC) H01L H01B |
| Y | JP 2000 348547 A (FUJIKURA LTD) 15 December 2000 (2000-12-15) * figure 1 * ----- | 1 | |

The present search report has been drawn up for all claims

| Place of search | Date of completion of the search | Examiner |
|---|---|---|
| Munich | 24 April 2009 | Meul, Hans |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 00 2671

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2009

| Patent document cited in search report | | Publication date | Patent family member(s) | | Publication date |
|---|---|---|---|---|---|
| US 5127149 | A | 07-07-1992 | EP<br>JP<br>WO | 0517825 A1<br>7502367 T<br>9113468 A1 | 16-12-1992<br>09-03-1995<br>05-09-1991 |
| US 2007186998 | A1 | 16-08-2007 | JP | 2007214002 A | 23-08-2007 |
| JP 2000348547 | A | 15-12-2000 | JP | 3585770 B2 | 04-11-2004 |

EPO FORM P0459

For more details about this annex : see Official Journal of the European Patent Office, No. 12/82

**REFERENCES CITED IN THE DESCRIPTION**

**Patent documents cited in the description**

- JP 49114389 A

**Non-patent literature cited in the description**

- *IEEE Transaction on Magnetics,* May 1983, vol. MAG-19 (3), 1131-1134
- *IEEE Transaction on Applied Superconductivity,* June 2005, vol. 15 (2), 1200-1204